(19) Europäisches Patentamt
European Patent Office
Office européen des brevets

(11) **EP 3 338 099 B1**

(12) **EUROPÄISCHE PATENTSCHRIFT**

(45) Veröffentlichungstag und Bekanntmachung des Hinweises auf die Patenterteilung:
**08.05.2024 Patentblatt 2024/19**

(21) Anmeldenummer: **16758128.9**

(22) Anmeldetag: **22.08.2016**

(51) Internationale Patentklassifikation (IPC):
**G01R 31/12** (2020.01)   **G01R 31/14** (2006.01)
**G01R 31/00** (2006.01)   **G01R 31/08** (2020.01)
**G01R 31/69** (2020.01)   **G01R 35/00** (2006.01)

(52) Gemeinsame Patentklassifikation (CPC):
**G01R 31/1272; G01R 31/14;** G01R 31/008;
G01R 31/08; G01R 31/69; G01R 35/00

(86) Internationale Anmeldenummer:
**PCT/EP2016/069841**

(87) Internationale Veröffentlichungsnummer:
**WO 2017/029415 (23.02.2017 Gazette 2017/08)**

(54) **VERFAHREN UND MESSAUFBAU ZUR MESSUNG VON TEILENTLADUNGEN IN STECKVERBINDUNGEN UND VERWENDUNG FÜR STECKVERBINDUNGEN EINES SCHIENENFAHRZEUGS**

METHOD AND TEST SETUP FOR MEASURING PARTIAL DISCHARGES IN PLUG CONNECTIONS AND USE FOR PLUG CONNECTIONS IN A RAIL VEHICLE

PROCÉDÉ ET SYSTÈME DE MESURE DESTINÉ À LA MESURE DE DÉCHARGES PARTIELLES DES CONNECTEURS ET UTILISATION POUR DES CONNECTEURS D'UN VÉHICULE FERROVIAIRE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **20.08.2015 DE 102015113804**

(43) Veröffentlichungstag der Anmeldung:
**27.06.2018 Patentblatt 2018/26**

(73) Patentinhaber: **ALSTOM Holdings**
**93400 Saint-Ouen-sur-Seine (FR)**

(72) Erfinder:
• **ESTERL, Florian**
**13357 Berlin (DE)**
• **MAASS, Jörg-Torsten**
**16515 Oranienburg (DE)**

(74) Vertreter: **Zimmermann & Partner**
**Patentanwälte mbB**
**Postfach 330 920**
**80069 München (DE)**

(56) Entgegenhaltungen:
**CN-A- 104 698 355    JP-A- H0 815 367**

• **DENISSOV D ET AL: "Wide and narrow band PD detection in plug-in cable connectors in the UHF range", CONDITION MONITORING AND DIAGNOSIS, 2008. CMD 2008. INTERNATIONAL CONFERENCE ON, IEEE, PISCATAWAY, NJ, USA, 21. April 2008 (2008-04-21), Seiten 1056-1059, XP031292679, ISBN: 978-1-4244-1621-9**
• **BABAEE ABBAS ET AL: "On-line partial discharge source location in single-core cables with multi sheath-ground connections", IEEE TRANSACTIONS ON DIELECTRICS AND ELECTRICAL INSULATION, IEEE SERVICE CENTER, PISCATAWAY, NJ, US, Bd. 22, Nr. 2, 1. April 2015 (2015-04-01), Seiten 1031-1040, XP011578143, ISSN: 1070-9878, DOI: 10.1109/TDEI.2015.7076805 [gefunden am 2015-04-01]**

- CAVALLINI A ET AL: "A novel method to locate PD in polymeric cable systems based on amplitude-frequency (AF) map", IEEE TRANSACTIONS ON DIELECTRICS AND ELECTRICAL INSULATION, IEEE SERVICE CENTER, PISCATAWAY, NJ, US, Bd. 14, Nr. 3, 1. Juni 2007 (2007-06-01), Seiten 726-734, XP011185134, ISSN: 1070-9878, DOI: 10.1109/TDEI.2007.369537
- HAO L ET AL: "Discrimination of multiple PD sources using wavelet decomposition and principal component analysis", IEEE TRANSACTIONS ON DIELECTRICS AND ELECTRICAL INSULATION, IEEE SERVICE CENTER, PISCATAWAY, NJ, US, Bd. 18, Nr. 5, 1. Oktober 2011 (2011-10-01), Seiten 1702-1711, XP011386048, ISSN: 1070-9878, DOI: 10.1109/TDEI.2011.6032842

## Beschreibung

Die Erfindung betrifft ein Verfahren zur Messung von Teilentladungen in elektrischen Steckverbindungen im Mittelspannungsbereich, insbesondere in einem Schienenfahrzeug, einen Messaufbau zur Messung von Teilentladungen, sowie eine Verwendung eines derartigen Messaufbaus zum Identifizieren von Teilentladungen aus Steckverbindungen eines Schienenfahrzeugs.

Die Messung von Teilentladungen (TE) ist eine empfindliche Messmethode zur Erkennung von Schwachstellen in Isolierungen. In einer TE-Messung werden an den Anschlüssen der zu prüfenden Vorrichtung sehr kleine, impulsartige Ströme gemessen, die aufgrund der Teilentladungen in Schwachstellen auftreten. Gemäß der DIN EN/IEC 60270 wird der TE-Strom an einer Koppeleinheit (CD) (gemäß DIN EN 60270 "Koppeleinheit") gemessen, das den hochfrequenten TE-Strom von dem niederfrequenten Betriebsstrom trennt und üblicherweise in Reihe mit einem Koppelkondensator oder - sofern möglich - mit dem Prüfobjekt geschaltet ist. Die Reihenschaltung mit dem Prüfobjekt kann die Messgenauigkeit erhöhen, weil auch Anteile von Teilentladungsströmen von parasitären Kapazitäten erfasst werden können. Die Koppeleinheit beinhaltet eine Messimpedanz, mit der der hochfrequente TE-Strom gemessen wird. Alternativ werden auch Hochfrequenz-Stromwandler (High-Frequency-Current-Transformer (HFCT)) zur Messung des TE-Strom angewendet. Ein grundsätzliches Problem von Vor-Ort TE-Messungen sind einkoppelnde impulsförmige Störsignale aus der Umgebung, sowie die Überlagerung verschiedener TE-Quellen während der Messung. Diese können eine zuverlässige Identifizierung und Analyse von einzelnen TE-Quellen erschweren bzw. verhindern, da sie oft nicht voneinander unterscheidbar sind und somit zu Fehlinterpretationen der Messungen führen können.

Folgende Veröffentlichungen befassen sich mit Messungen von Teilentladungen: DENISSOV D ET AL: "Wide and narrow band PD detection in plug-in cable connectors in the UHF range", CONDITION MONITORING AND DIAGNOSIS, 2008. CMD 2008. INTERNATIONAL CONFERENCE ON, IEEE, PISCATAWAY, NJ, USA, 21. April 2008, Seiten 1056-1059, XP031292679, ISBN: 978-1-4244-1621 9; BABAEE ABBAS ET AL: "Online partial discharge source location in single-core cables with multi sheath-ground connections", IEEE TRANSACTIONS ON DIELECTRICS AND ELECTRICAL INSULATION, IEEE SERVICE CENTER, PISCATAWAY, NJ, US, B,d.22, Nr.2, 1. April 2015, Seiten 1031-1040, XP011578143, ISSN: 1070-9878, DOI: 10.1109/TDE1.2015.7076805; CAVALLINI A ET AL: "A novel method to locate PD in polymeric cable systems based on amplitude-frequency (AF) map", IEEE TRANSACTIONS ON DIELECTRICS AND ELECTRICAL INSULATION, IEEE SERVICE CENTER, PISCATAWAY, NJ, US, Bd. 14, Nr. 3, 1 . Juni 2007, Seiten 726-734, XP0111851 34, ISSN: 1070-9878, DOI: 1 0.1109/TDE1.2007.369537; HAO L ET AL: "Discrimination of multiple PD sources using wavelet decomposition and principal component analysis", IEEE TRANSACTIONS ON DIELECTRICS AND ELECTRICAL INSULATION, IEEE SERVICE CENTER, PISCATAWAY, NJ, US, Bd. 18, Nr.5, 1. Oktober 2011, Seiten 1702-1711, XP011386048, ISSN: 1070-9878, DOI: 10.1109/TDEI.2011.6032842. Des Weiteren befassen sich folgenden Patentanmeldungen mit Messungen von Teilentladungen: CN 104 698 355 A und JP H08 15367 A.

Moderne, digitale Teilentladungsmesssysteme ermöglichen eine synchrone Echtzeitmessung von TE mit einer Vielzahl von Datenerfassungseinheiten. Die an einer Koppeleinheit gemessenen TE-Signale werden in der Datenerfassungseinheit in Echtzeit digitalisiert und aufbereitet. Ein digitaler Bandpass-Filter bestimmt die elektrische Ladung eines gemessenen TE-Impulses. Anschließend werden charakteristische Parameter des TE-Ereignisses mittels Glasfaser an einen PC übertragen, an dem die aufgezeichneten Daten abgespeichert und mit statistischen Methoden analysiert werden können. Die Darstellung der TE-Ereignisse erfolgt üblicherweise in einem Phase Resolved Partial Discharge (PRPD) Diagramm, in welchem die Phasenlage und Häufigkeit der hochfrequenten TE-Ereignisse über der Prüfspannung dargestellt wird. Die synchrone Messung ermöglicht, die Signale eines einzelnen TE-Ereignisses an verschiedenen Auskopplungspunkten mit jeweils einer eigenen TE-Erfassungseinheit zu messen, was für vorteilhafte Methoden zur Separierung verschiedener TE-Quellen und Störungen, z.B. das 3-Phase-Amplitude-Relation-Diagram (3PARD), erforderlich ist. Des Weiteren ist es möglich die Ladung eines mit der TE-Erfassungseinheit gemessenen TE-Impulses simultan mit drei Bandpass-Filtern mit unterschiedlicher Mittenfrequenz zu bestimmen. Dies ist für ein weiteres zur Separierung und Störunterdrückung verwendetes Verfahren, das 3-Center-Frequency-Relation-Diagram: 3CFRD, nötig.

Sowohl 3PARD als auch 3CFRD nutzen aus, dass TE-Impulse und Störer aus verschiedenen Quellen auf Grund von Impulsverformungen bei der Impulsausbreitung oft unterschiedliche Impulsformen und -amplituden am Auskoppelpunkt aufweisen. Während der Ausbreitung des TE-Impulses von dem Ort seines Ursprungs (TE-Quelle) bis zum Auskopplungspunkt kann der TE-Impuls durch galvanische, induktive und kapazitive Kopplungen sowie durch Reflexionsvorgänge an Sprungstellen der Wellenimpedanzen beeinflusst werden. Dies führt zu einer charakteristischen, frequenzabhängigen Dämpfung und Verformung der Impulsform und seiner Energie. Die endgültige Impulsform an dem Auskopplungspunkt wird von dem Einfluss des Ausbreitungspfades des Impulses dominiert.

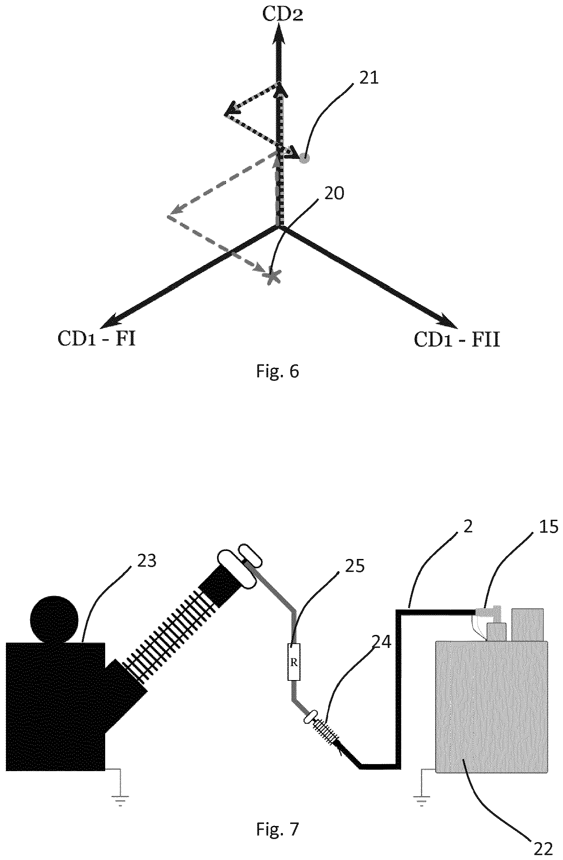

Bei dem Auswerteverfahren 3PARD werden die TE-Impulse an drei verschiedenen Auskoppelpunkten mit drei TE-Erfassungseinheiten synchron gemessen und die Ergebnisse in einem Diagramm kombiniert angezeigt. Der Einfluss des Ausbreitungsweges eines einzelnes TE-Ereignisses vom Entstehungsort zu den Auskoppelpunkten führt zu unterschiedlichen Impulsformen an den drei Auskoppelpunkten, einschließlich unterschiedlicher Amplituden. Aufgrund der deterministischen und über die Zeit gleichbleibenden Übertragungsfunktionen der Ausbreitungspfade zu den drei Auskopplungspunkten ist das Verhältnis der drei gemessenen Signalamplituden (sogenannte TE-Tripel) für alle nachfolgenden Teilentladungsereignisse nahezu gleich, ungeachtet der eigentlichen Ladungshöhe einer einzelnen TE am Ursprungsort. Wegen des dominierenden, charakteristischen Einflusses des Ausbreitungspfades auf die Wellenform des Impulses haben verschiedene TE-Quellen an unterschiedlichen Orten mit Unterschieden in den Ausbreitungspfaden unterschiedliche Amplitudenverhältnisse an den drei Auskopplungspunkten zur Folge. Das 3-Phase-Amplitude-Relation-Diagram (3PARD) visualisiert die Amplitudenverhältnisse jedes gemessenen TE-Ereignisses in einem dreiachsigen Diagramm (Fig. 6). Jede TE-Erfassungseinheit ist einer der jeweils 120° zueinander gedrehten drei Achsen zugeordnet. Eine Vektoraddition der Vektoren, deren Länge mit der Amplitude bzw. der ermittelten elektrischen Ladung des TE-Signals korreliert, führt zu Punkten in einem für die Amplitudenverhältnisse charakteristischen Bereich des 3PARD, wodurch unterschiedliche TE-Quellen und Störungen separiert werden können.

Mit einer Mehrfrequenzmessung kann ein 3-Center-Frequency-Relation-Diagram (3CFRD) erzeugt werden. Dieses basiert auf der gleichen Berechnungsmethode und Visualisierung wie 3PARD, benötigt jedoch nur eine TE-Erfassungseinheit. Die drei für das TE-Tripel erforderlichen Amplituden werden durch drei digitale Bandpass-Filter mit unterschiedlichen Mittenfrequenzen $f_c$ erzeugt, die simultan in der TE-Erfassungseinheit angewendet werden. Indem Filter auf verschiedene Frequenzbereiche angewendet werden, können Unterschiede der Frequenzspektren der TE-Impulse aus unterschiedlichen TE-Quellen, die aufgrund der charakteristischen Ausbreitungspfade entstehen, visualisiert werden.

Ein Problem bei einer TE-Messung auf einem Schienenfahrzeug ist, dass die Messung von erheblichen Störungen überlagert sein kann. Störungen können durch Einkopplungen von Störsignalen aus der Umgebung sowie durch unkritische TE in benachbarten Komponenten, wie z.B. dem Fahrzeugtransformator, verursacht werden. Störende TE-Quellen während einer TE-Messung an Steckverbindungen können interne TE vom angeschlossenen Transformator oder Korona- und Oberflächenentladungen nahe dem Kabelendverschluss auf dem Fahrzeugdach sein. Aufgrund der kurzen Kabellängen und der kurzen Abstände zwischen der Steckverbindung und dem Fahrzeugtransformator werden diese überlagernden TE während der Ausbreitung des Spannungsimpulses kaum gedämpft. Eine Unterscheidung von TE aus der Steckverbindung und anderen Signalen, z.B. aus eingekoppelten Störer oder TE in den anderen beteiligten Komponenten, ist dadurch kaum möglich.

Transformatoren, insbesondere Fahrzeugtransformatoren, können eine Niederspannungsseite und/oder eine Mittelspannungsseite und/oder Hochspannungsseite aufweisen.

Aufgabe der vorliegenden Erfindung ist folglich, eine Messmethode und einen Messaufbau bereitzustellen, die es ermöglicht, TE einer Steckverbindung, insbesondere im Mittelspannungsbereich, im Gesamtsystem vor Ort zuverlässig zu identifizieren und von den restlichen, überlagerten Signalen zu separieren.

Diese Aufgabe wird gelöst durch ein Verfahren nach Anspruch 1. Des Weiteren wird die Aufgabe durch einen Messaufbau gemäß Anspruch 6 sowie durch die Verwendung eines derartigen Messaufbaus zum Identifizieren von Teilentladungen aus Steckverbindungen eines Schienenfahrzeugs nach Anspruch 11 gelöst. Weitere Ausführungsformen, Modifikationen und Verbesserungen ergeben sich anhand der folgenden Beschreibung und der beigefügten Ansprüche.

Das erfindungsgemäße Messverfahren erlaubt eine empfindliche und selektive Messung von Teilentladungen und eine Unterscheidung von TE aus dem Stecker bzw. der Steckverbindung und anderen störenden Signalen. Das Messverfahren beruht auf einer zeitsynchronen Messung der TE in zwei Auskoppelpunkten und dem anschließenden Vergleich der Ladungshöhen. Das erfindungsgemäße Messverfahren eignet sich insbesondere für die Prüfung von elektrischen Verbindungen auf Schienenfahrzeugen und vergleichbaren Anlagen der Mittelspannung vor Ort. Es ermöglicht, Steckverbindungs-TE z.B. in Schienenfahrzeugen oder Windkraftanlagen verlässlich zu identifizieren und von Störsignalen, wie z.B. externen TE oder elektromagnetischen Störungen zu separieren. Eine Verwendung des erfindungsgemäßen Verfahrens in Stückprüfungen kann die Verfügbarkeit solcher Anlagen verbessern und helfen, teure Ausfälle und Beschädigungen aufgrund elektrischer Durchschläge zu vermeiden. Der einfache Aufbau der Messvorrichtung ermöglicht zudem eine mobile Anwendung bei unterschiedlichen Störbedingungen. Mit dem erfindungsgemäßen Verfahren zur Messung von Teilentladungen können Montagefehler, wie nicht montierte Schraubeinsätze, beschädigte Steckererdungen oder nicht entfernte Schutzkappen der Steckdurchführung erkannt werden.

Im Folgenden wird die Anwendung des Messverfahrens am Beispiel eines Schienenfahrzeugs beschrieben.

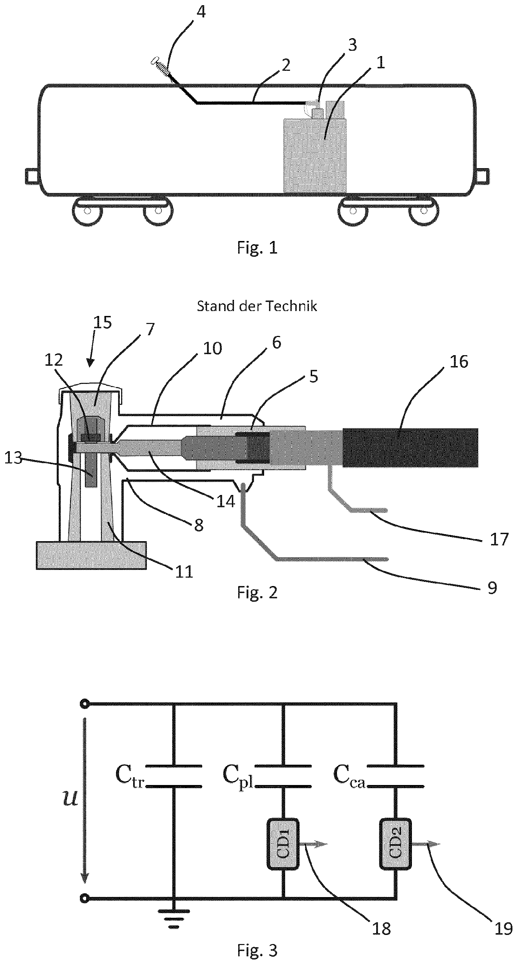

Für den Anschluss von Fahrzeugtransformatoren in Schienenfahrzeugen an auf dem Fahrzeugdach montierten Schaltanlagen bei einer Wechselspannung von 15 kV bzw. 25 kV werden gewöhnlich Mittelspannungssteckverbinder verwendet. Häufig werden Stecker mit Außenkonus-Technik für Einsteck-Durchführungen gemäß Anschlusstyp C nach DIN:EN 50180 und DIN:EN 50181 eingesetzt (s. Fig. 2 und Figurenbeschreibung). Bei einer korrekten Ausführung des Steck- und Montagevorgangs entsteht eine kompakte und geschirmte Verbindung zwischen Kabel und Transformator, wobei gewöhnlich bei einer Prüfspannung von 2 $U_0$ ($U_0$: Effektivwert der nominalen Leiter-Erde-Spannung) keine Teilentladungen auftreten.

Oft ist auf Schienenfahrzeugen keine Verlegung der Kabel mit vormontierten Steckern mit Außenkonus-Technik am Stück möglich, weil der Stecker breitere Abmessungen aufweist als das Kabel und somit die Verlegung durch enge Stellen der Fahrzeugkonstruktion verhindert werden würde. Aus diesem Grund werden die vormontierten und vorgeprüften Stecker häufig vor der Kabelverlegung vom Kabel getrennt. Die Kabel werden dann erst nach der Kabelverlegung auf dem Fahrzeug wieder mit dem Stecker verbunden, und der Stecker wird erst auf dem Fahrzeug mit dem Fahrzeugtransformator verbunden. Gleiches trifft für eine Reparatur nach einem Fehler am Stecksystem zu. Es gibt eine Reihe von Fehlerszenarien, verursacht durch nicht korrektes Montieren und Zusammenstecken. Neben unzureichender Reinigung der Schnittstellen der Isolierung von nichtleitenden und leitenden Partikeln können Beschädigungen an Einsteck-Durchführungen und Isoliereinsätzen sowie vergessene Isoliereinsätze und schlechte Kontakte des Erdungsleiters zu einer fortschreitenden Schwächung mit anschließendem Versagen der elektrischen Isolierung führen. Neben dem Zusammenbruch der Stromversorgung können elektrische Durchschläge fehlerhaft montierter Steckverbinder auf dem Schienenfahrzeug in der Nähe befindliche Personen und Ausstattungsgegenstände gefährden und zu ungeplanten Ausfällen des Schienenfahrzeugs führen.

Zur Prüfung der Qualität der Montage und der Steckverbindung ist ein Test nach der Installation am Fahrzeug erforderlich. Normgerechte Stehwechselspannungs- und Stehstoßspannungs-Prüfungen lassen sich einerseits bezüglich der Steckverbindung zum Transformator häufig nicht durchführen und sind anderseits für die Bewertung der Qualität auch nicht ausreichend, weil ein durch TE hervorgerufener elektrischer Durchschlag erst verzögert auftritt.

In einer bevorzugten Ausführungsform des erfindungsgemäßen Messverfahrens werden zwei in zwei Koppeleinheiten mit angeschlossenen TE-Erfassungseinheiten synchron gemessene Ladungen der TE verglichen. Die zwei Koppeleinheiten haben vorzugsweise ein übereinstimmendes Frequenzverhalten bzw. die gleiche Übertragungsfunktion. Bevorzugt ist der Frequenzgang der Koppeleinheiten in einem Bereich von 0 bis 8 MHz konstant.

Das Verfahren macht sich die drei Hauptkapazitäten des Messkreises zu Nutze. Die verwendeten Hauptkapazitäten sind die Kapazität der Transformatorwicklung $C_{tr}$, die Kapazität des Steckers $C_{pl}$ und die Kapazität des Anschlusskabels $C_{ca}$ (s. Fig. 3). Hierbei ist die Kapazität des Steckers die kleinste der drei Hauptkapazitäten. Die erste Koppeleinheit (CD1) wird in dem Erdungsleiter des Steckers installiert, die zweite Koppeleinheit (CD2) in dem Erdungsleiter des Kabels. Sobald eine TE mit einer elektrischen Ladung $q_a$ in einer der drei Kapazitäten auftritt, werden Ladungen zwischen den drei Kapazitäten übertragen, um den TE-bedingten Spannungseinbruch der von der TE betroffenen Kapazität auszugleichen. Dadurch entsteht an allen drei Kapazitäten ein kleiner Spannungsabfall

$$\Delta u^* = \frac{q_a}{(C_{tr}+C_{pl}+C_{ca})} \quad (1)$$

Es können drei Szenarien unterschieden werden: Eine TE im Stecker bzw., eine TE bzw. ein Störimpuls im Kabel und seinem Endverschluss, sowie eine TE bzw. ein Störimpuls im Transformator.

Tritt eine TE im Stecker auf, fließen Ladungen von der Kapazität des Transformators $C_{tr}$ und der Kapazität des Kabels $C_{ca}$ in die Kapazität des Steckers $C_{pl}$. Beide Ladungen fließen durch die Koppeleinheit CD1. Die messbare Ladung $q_{m1}$ im CD1 ist somit:

$$q_{m1}=(C_{tr}+C_{ca}) \cdot \Delta u^* \quad (2)$$

Die messbare Ladung in CD2 besteht hingegen nur aus der Ladung, die aus der Kabelkapazität fließt:

$$q_{m2}=C_{ca} \cdot \Delta u^* \quad (3)$$

Folglich ist bei einer Stecker-TE die messbare Ladung im CD1 größer als im

$$CD2: q_{m1}> q_{m2} \quad (4)$$

Tritt eine TE an dem Endverschluss des Kabels oder im Kabel auf, fließen kompensierende Ladungen von der Kapazität $C_{tr}$ und $C_{pl}$ in die Kapazität des Kabels $C_{ca}$. In Koppeleinheit CD1 ist in diesem Fall nur die Ladung messbar, die aus der kleinen Steckerkapazität fließt. Diese ist aufgrund der kleinen Kapazität des Steckers vergleichsweise klein:

$$q_{m1} = C_{pl} \cdot \Delta u^* \quad (5)$$

Die messbare Ladung in der Koppeleinheit CD2 besteht aus der Ladung der Steckerkapazität und der Transformatorkapazität:

$$q_{m1}=(C_{pl}+C_{tr}) \cdot \Delta u^* \quad (6)$$

Somit ist in diesem Fall die im CD2 messbare Ladung größer als die im CD1 messbare Ladung:

$$q_{m1} < q_{m2} \quad (7)$$

Falls eine TE im Transformator oder ein Störimpuls auf der Niederspannungsseite des Transformators auftritt, werden die Ladungen von den Kapazitäten $C_{pl}$ und $C_{ca}$ in den Transformator fließen. In der Koppeleinheit CD1 ist somit nur die aus der Steckerkapazität $C_{pl}$ fließende Ladung messbar:

$$q_{m1} = C_{pl} \cdot \Delta u^* \quad (8)$$

Die Ladung, die durch die Koppeleinheit CD2 fließt, entspricht der Ladung, die aus der Kabelkapazität fließt:

$$q_{m2} = C_{ca} \cdot \Delta u^* \quad (9)$$

Weil auch bei kurzen Kabeln, z.B. mit einer Länge von 2,5 m, die Kabelkapazität $C_{ca}$ größer ist als die Kapazität des Steckers $C_{pl}$, ist die messbare Ladung in der Koppeleinheit CD1 erneut kleiner als in der Koppeleinheit

$$CD2: q_{m1} < q_{m2} \quad (10)$$

Ein Vergleich der oben aufgeführten Gleichungen 4, 7 und 10 zeigt, dass für eine Stecker-TE die im CD1 messbare Ladung größer ist als die im CD2 messbare Ladung. Bei externen Teilentladungen bzw. Störimpulsen, z.B. TE im Transformator oder an dem KabelEndverschluss, ist dieses Verhältnis umgekehrt. Somit erlaubt ein Vergleich dieser zwei messbaren Ladungen, eine Teilentladung im Stecker von externen Teilentladungen oder Störimpulsen zu unterscheiden.

Teilentladungen werden in einer vorteilhaften Ausführung des erfindungsgemäßen Verfahrens in einem Diagramm mit drei Achsen, ähnlich dem 3-Phase-Amplitude-Relation-Diagram (3PARD), abgebildet, wobei die Werte für die dritte Achse durch einen weiteren Bandpass-Filter in einem der an die Koppeleinheiten (CD1, CD2) angeschlossenen TE-Erfassungseinheiten erzeugt werden. Für die praktische Umsetzung des Ladungsvergleichs kann eine Darstellung in einem 3PARD-Diagram verwendet werden. Hierfür wird z.B. in der an CD1 angeschlossenen TE-Erfassungseinheit ein zweiter Bandpass-Filter FII zur Bestimmung der elektrischen Ladung des TE-Impulses angewendet. Dieser zweite Filter der Koppeleinheit CD1 ermöglicht, die Messgenauigkeit zu erhöhen, indem der erste Filter FI kalibriert wird und die Einstellungen des zweiten Filters FII auch während der Messung für eine flexible Reaktion auf wechselnde Störungsbedingungen angepasst werden. Im Gegensatz zu den Spektren der Stecker-TE haben die Spektren externer TE auf Grund der längeren Ausbreitungswege eine weniger konstante Ausprägung. Der zweite Filter FII kann daher genutzt werden, um die Clusterposition im 3PARD zu beeinflussen und die Trennung der Cluster zu verbessern. Die TE-Ereignisse von ausgewählten Bereichen im 3PARD können anschließend wieder in die übliche phasenaufgelöste Darstellung (PRPD Diagramm) rücktransformiert werden und in dieser Darstellung weiter analysiert werden. Dies ermöglicht es, von Störungen und vielen TE-Quellen überlagerte PRPD Diagramme in ein separiertes PRPD Diagramme zu überführen, in welchem nur eine TE-Quelle dargestellt wird und daher vorteilhaft analysiert werden kann.

Zur Durchführung des Messverfahrens ist der Steckerschirm mit einem separaten Erdungsleiter versehen. Der Steckerschirm ist somit nicht direkt leitend mit der Kabelschirmung verbunden sein, z.B. über die Leitschichten.

Höhere Frequenzanteile von TE-Impulsen können durch den häufig aus extrudiertem, schwach leitendem Material bestehenden Steckerschirm stark gedämpft werden. Um Teilentladungen auch bei höheren Messfrequenzen mit hoher Genauigkeit erfassen zu können, kann der schwach leitende Schirm des Steckers durch eine leitfähige Hülle überbrückt werden. In einer bevorzugten Ausführungsform des Messaufbaus kann die leitfähige Hülle eine leitfähige Folie umfassen bzw. von einer leitfähigen Folie gebildet sein.

Das erfindungsgemäße Messverfahren hat des Weiteren die folgenden vorteilhaften Eigenschaften:

- Stecker-TE können durch die Anordnung von Punktclustern in einem 3PARD identifiziert werden. Unter Anwendung geeigneter Software kann ein Punktcluster in ein PRPD zurücktransformiert werden, frei von überlagerten TE und Störungen.

- Die Installation der Koppeleinheit CD1 in dem Erdungsleiter des Steckers ermöglicht eine hohe Sensitivität zur Erkennung von Stecker-TE, weil sämtliche externen Kapazitäten (Transformatorkapazität, Kabelkapazität) als Koppelkapazitäten (Ladungsreservoir für TE-Ausgleichsströme) genutzt werden und die Auskopplung des Signals der Stecker-TE sehr nah an seinem Ursprung liegt. Auf einen, bei TE-Messungen häufig verwendeten, zusätzlichen Koppelkondensator kann somit verzichtet werden, wodurch Kosten, Gewicht und Aufwand des Messaufbaus verringert werden.

- Eine erste Koppeleinheit weist bevorzugt eine geringere Empfindlichkeit für externe TE und Störungen auf, aufgrund der kleinen Kapazität des Steckers. Verglichen mit dem üblichen TE-Messaufbau mit zusätzlichem Koppelkondensator können hierdurch die TE-Signale aus dem Stecker in der, an diese Kopplungseinheit angeschlossenen, TE-Erfassungseinheit stärker vorverstärkt werden. Dies verringert die Höhe des Grundrauschens und erhöht damit die Sensitivität der Messung von Stecker-TE.
- Das erfindungsgemäße Verfahren ist für unterschiedliche Arten von Transformatoren geeignet sowie für unterschiedliche Arten geschirmter Stecker und kann somit für Stückprüfungen im Schienenfahrzeugbereich verwendet werden.

Die beiliegenden Zeichnungen veranschaulichen Ausführungsformen und dienen zusammen mit der Beschreibung der Erläuterung der Prinzipien der Erfindung. Die Elemente der Zeichnungen sind relativ zueinander und nicht notwendigerweise maßstabsgetreu. Gleiche Bezugszeichen bezeichnen entsprechend ähnliche Teile.

Fig. 1 ist eine schematische Darstellung der an einer Teilentladungsmessung auf einem Schienenfahrzeug beteiligten Mittelspannungskomponenten.

Fig. 2 zeigt den Aufbau eines Außenkonus-Kabelstecker mit extrudierter, halbleitender Schirmung.

Fig. 3 zeigt die Anordnung der Hauptkapazitäten des Messkreises und die Installationspositionen der Koppeleinheiten (CD1, CD2).

Fig. 4 zeigt die Installation der Koppeleinheiten (CD1, CD2) und der Teilentladungserfassungseinheiten.

Fig. 5 zeigt das Spektrum einer Stecker-Teilentladung, gemessen in CD1 (oberes Spektrum) und CD2 (unteres Spektrum), sowie die parallele Anwendung dreier Bandpass-Filter I, II und III (vertikale Blöcke).

Fig. 6 ist eine schematische Darstellung der Clusterpositionen in einem 2CISM-Darstellung, ähnlich dem 3PARD.

Fig. 7 ist eine schematische Abbildung eines Messaufbaus zur Erfassung von Teilentladungen.

Fig. 8 ist eine schematische Abbildung einer weiteren vorteilhaften Ausführungsform eines Messaufbaus zur Erfassung von Teilentladungen.

Fig. 9 zeigt ein PRPD einer Steckerteilentladung des Messaufbaus gemäß Fig. 7, ohne zusätzliche Störquellen.

Fig. 10 zeigt ein überlagertes PRPD, bei dem mehrere TE-Quellen sowie Signalstörungen überlagert sind.

Fig. 11 zeigt eine 2CISM-Darstellung der Stecker-TE und der Störungen, gemessen mit dem erfindungsgemäßen Verfahren.

Fig. 12 zeigt ein separiertes PRPD der Stecker-TE gemäß Cluster 1 in Fig. 11.

In Fig. 1 sind die wesentlichen Komponenten eines Schienenfahrzeugs gezeigt, die bei einer TE-Messung auf einem Schienenfahrzeug Einfluss auf die Messung nehmen. An den Fahrzeugtransformator 1 ist ein Kabel 2 mit einem Stecker 3 angeschlossen. An dem gegenüberliegenden Ende des Kabels 2 ist ein Endverschluss 4 angeordnet.

Als Beispiel für eine elektrische Verbindung auf einem Schienenfahrzeug zeigt Fig. 2 einen Außenkonus-Kabelstecker 15 mit extrudierter Schirmung. Ein Stecker umfasst üblicherweise drei Hauptbestandteile: Ein feldsteuerndes Element 5, einen Steckerkörper 6 und einen Isoliereinsatz 7 bzw. Schraubeinsatz. Das feldsteuernde Element 5 wird auf das Kabelende 16 aufgeschoben, um eine Feldsteuerung am Ende der äußeren Leitschicht des Kabels bereitzustellen. Auch das angeschlossene Kabel ist mit einem Erdungsleiter 17 versehen. Der Steckerkörper ist gewöhnlich aus Silikongummi (SiR) oder Ethylen-Propylen-Dien-Kautschuk (EPDM) hergestellt. Der Schirm 8 des Steckerkörpers umfasst eine extrudierte Leitschicht, die über einen Erdungsleiter 9 des Steckers mit dem Erdpotential verbunden werden kann. Die innere Hochspannungs-Leitschicht 10 erzeugt eine kontrollierte Feldverteilung innerhalb der Steckerisolierung.

Der Stecker wird zur Montage auf die Einsteck-Durchführung 11 gedrückt und meist mit einer Mutter 12 und einem Bolzen 13 fixiert. Anschließend wird der Stecker mit dem Isoliereinsatz 7, der ebenfalls aufgeschraubt werden kann, isolierend geschlossen. Durch eine korrekte Ausführung des Steck- und Montagevorgangs entsteht eine kompakte und geschirmte Verbindung zwischen Kabel und Transformator, wobei gewöhnlich bei einer Prüfspannung von 2 $U_0$ keine Teilentladungen auftreten.

Das Schaltbild der Fig. 3 zeigt einen erfindungsgemäßen Messaufbau, mit dem erfindungsgemäß zwei in zwei Koppeleinheiten (CD) synchron gemessene Ladungen der TE verglichen werden. Jede Koppeleinheit ist für eine synchrone TE-Messung über dafür vorgesehene Ausgänge 18, 19 an einer digitalen TE-Datenerfassungseinheit angeschlossen. Die verwendeten drei Hauptkapazitäten des Messkreises sind die Kapazität der Transformatorwicklung $C_{tr}$, die Kapazität des Steckers $C_{pl}$ und die Kapazität des Anschlusskabels $C_{ca}$ (s. Fig. 3). Hierbei ist die Kapazität des Steckers die kleinste der drei Hauptkapazitäten. Die erste Koppeleinheit (CD1) wird in dem Erdungsleiter des Steckers installiert, die zweite Koppeleinheit (CD2) in dem Erdungsleiter des Kabels. Sobald eine TE mit einer elektrischen Ladung $q_a$ in einer der drei Kapazitäten auftritt, werden Ladungen zwischen den drei Kapazitäten übertragen, um den TE-bedingten Spannungseinbruch der von der TE betroffenen Kapazität auszugleichen. Dadurch entsteht an allen drei Kapazitäten der oben beschriebene kleine Spannungsabfall.

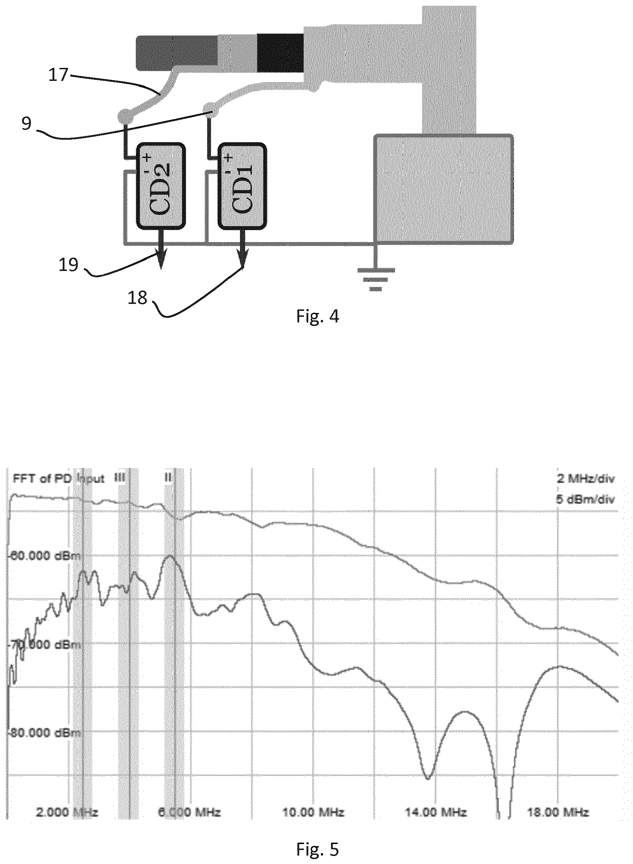

Fig. 4 zeigt die Anbindung der zwei Koppeleinheiten CD1, CD2. Jede Koppeleinheit ist für eine synchrone TE-Messung mit einem Erdungsleiter 9, 17 verbunden, wobei die Koppeleinheit CD2 mit dem Erdungsleiter 17 des Kabels und die Koppeleinheit CD1 mit der Erdung des Steckers 9 elektrisch leitend verbunden ist. Die Koppeleinheiten CD1 und CD2 sind des Weiteren über dafür vorgesehene Ausgänge 18, 19 jeweils an einer digitalen TE-Datenerfassungseinheit angeschlossen, z.B. einem Gerät MPD600 der Firma Omicron. Die zwei Koppeleinheiten sind somit bevorzugt sehr dicht beieinander angeordnet, optional jeweils mit digitaler TE-Datenerfassungseinheit, wodurch die Messausrüstung schnell und einfach angeschlossen werden kann. Der Zeitaufwand für die Zeit und den Aufwand zum Anschluss der Messausrüstung kann weiter reduziert werden, indem die Messausrüstung in einem gemeinsamen Gehäuse zusammengefasst und vorbereitet ist.

Der Vergleich der gemessenen Ladungen kann unter Anwendung des Darstellungs-Verfahrens wie im 3PARD erfolgen, das den Vergleich der Ladungshöhen abbildet und eine Rücktransformation in den Zeitbereich als separiertes Phase Resolved Partial Discharge (PRPD) Diagramm ermöglicht. Eine der drei Achsen des 3PARD ist der Koppeleinheit CD2 zugeordnet, die beiden anderen Achsen der Koppeleinheit CD1, wobei hier zwei Bandpassfilter mit zwei unterschiedlichen Mittenfrequenzen $f_I$ und $f_{II}$ zur Bestimmung zweier elektrischer Ladungswerte verwendet werden. Daher wird erfindungsgemäß anstelle eines reinen 3PARD mit drei benötigten TE-Erfassungseinheiten eine Kombination aus 3PARD und 3CFRD angewendet. Dies wird im Folgenden als 2-Channel-Identification-and-Separation-Method (2CISM-Darstellung) bezeichnet, die dasselbe Darstellungs-Verfahren nutzt wie 3PARD und 3CFRD.

Fig. 5 zeigt die Spektren von Steckverbindungs-TE, die in der Koppeleinheit CD1 (obere Kurve) bzw. in der Koppeleinheit CD2 (untere Kurve) gemessen wurden, wobei drei Bandpassfilter mit unterschiedlichen Mittenfrequenzen verwendet wurden. Mit einer Koppeleinheit mit einer geeigneten, möglichst breitbandigen und frequenzkonstanten Frequenzgangcharakteristik und der Verwendung einer leitfähigen Hülle auf dem Steckerschirm kann eine Stecker-TE mit einem relativ konstanten Spektrum in der Koppeleinheit CD1 gemessen werden (Fig. 5, oberes Spektrum). In diesem Fall sind die ermittelten Ladungen der beiden Bandpass-Filter der Koppeleinheit CD1 nahezu gleich groß.

Fig. 6 zeigt eine schematisches 2CISM-Darstellung, bei der die Koppeleinheit CD2 der vertikalen Achse und die beiden Filter vom CD1 den beiden anderen Achsen zugeordnet sind. Der Stern 20 repräsentiert eine einzelne Stecker-TE, der Punkt 21 eine externe TE, z.B. eine TE im Transformator, oder einen eingekoppelten Störimpuls. Wie oben beschrieben ist die im CD1 gemessene Ladung $q_{m1}$ einer Stecker-TE größer als die im CD2 gemessene Ladung $q_{m2}$. Daher sind die beiden nach unten gerichteten (gestrichelten) Vektoren länger als der nach oben gerichtete Vektor. Die Vektoraddition wird somit zu einem Punkt im unteren Bereich der 2CISM-Darstellung führen (gestrichelte Vektoren). Andererseits führt eine externe TE zu einem Punkt im oberen Bereich der 2CISM-Darstellung, weil der nach oben gerichtete Vektor von $q_{m2}$ in diesem Fall länger ist als die nach unten gerichteten Vektoren von $q_{m1}$ (hellgraue Vektoren). Das Ergebnis ist, dass Stecker-TE zu Punktclustern im unteren Bereich der 2CISM-Darstellung führen, während externe TE und Störsignale Punktcluster im oberen Bereich zur Folge haben. Somit ermöglicht das erfindungsgemäße Verfahren eine Identifizierung von Stecker-TE anhand der Lage der Punktcluster in der 2CISM-Darstellung. Durch eine RückTransformation ausgewählter Cluster in ein separiertes Phase Resolved Partial Discharge (PRPD) Diagramm können TE aus dem Stecker von überlagerten TE bzw. Störungen separiert dargestellt und analysiert werden.

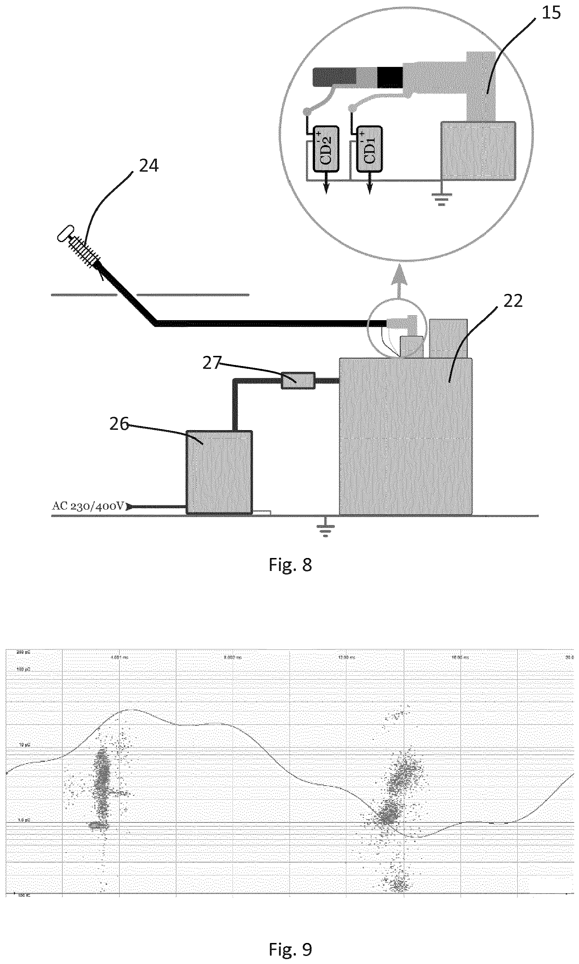

In Fig. 7 und 8 sind zwei mögliche Messaufbauten abgebildet: Gemäß Fig. 7 ist ein Fahrzeugtransformator 22 über einen montierten Außenkonus-Stecker 15 mit einem Kabel 2 verbunden. Soll der Fahrzeugtransformator nicht mitgeprüft werden oder steht kein Fahrzeugtransformator für die Spannungsversorgung zur Verfügung, kann zusätzlich ein Prüftransformator als Teil des Messaufbaus verwendet werden. In der Ausführungsform des Messaufbaus gemäß Fig. 7 ist ein Prüftransformator 23 vorgesehen, der an dem Endverschluss 24 des Kabels über einen Dämpfungswiderstand 25 angeschlossen ist und den Messaufbau mit Spannung beaufschlagt. Die angewendete Prüfspannung kann beispielsweise 30 kV betragen. Die Messausrüstung ist bevorzugt wie in Fig. 4 gezeigt angeschlossen. Der Filter FI der Koppeleinheit CD1 kann für Stecker-TE kalibriert werden. Um zu vermeiden, dass ein Versatz der Positionen der Punktcluster im 3PARD auftritt, kann der auf den Filter FI angewendete Kalibrierfaktor auch auf den Filter FII angewendet werden.

In einem Verfahren zum Testen eines erfindungsgemäßen Messaufbaus und Messverfahrens können mit diesem Aufbau mit zusätzlichem Prüftransformator 23 TE im Stecker künstlich erzeugt werden, z.B. indem elektrisch leitende Partikel in den Stecker eingebracht werden. Der Isoliereinsatz des Steckers (s. Fig. 2) kann mit einer Aussparung versehen sein, die einen Hohlraum zwischen Stecker-Innenleiter und Steckerschirmung zur Folge hat. In einem bevorzugten Testverfahren zum Testen des erfindungsgemäßen Prüfverfahrens wird ein Kupferpartikel in den o.g. Hohlraum eingesetzt, um die Teilentladungs-Einsetzspannung herabzusetzen. Die Ladungshöhen dieser künstlich erzeugten TE-Quelle im Stecker können zwischen 1 und 40 Pikocoloumb [pC] liegen, bevorzugt sind die Ladungen kleiner 10 Pikocoloumb.

In einem Testlauf können zudem Transformatoren eingesetzt werden, die bei der verwendeten Prüfspannung interne TE aufweisen. Alternativ oder zusätzlich können am Kabelendverschluss Quellen für Korona-Entladungen und Oberflächenentladungen installiert werden. Über einen Impulsgenerator und einen Ferritkern sowie einen Antennenaufbau können zudem sich schnell wiederholende Impulse in den Prüfkreis eingeleitet werden. Des Weiteren können Störungen erzeugt werden, z.B. durch eine über einen Wechselrichter betriebene, nah am Transformator angeordnete Pumpe.

Gemäß einer Ausführungsform weist der Messaufbau eine Energieversorgungseinheit auf, die vorgesehen ist, mit einer Niederspannungsseite oder Mittel- oder Hochspannungsseite eines Fahrzeugtransformators verbunden zu werden.

Fig. 8 zeigt einen für Routineprüfungen an Schienenfahrzeugen bevorzugten Messaufbau. Dieser umfasst neben den zuvor genannten Komponenten eine Energieversorgungseinheit 26, die über einen Filter 27 mit dem Fahrzeugtransformator verbunden ist. Die Energie- bzw. Stromversorgungseinheit ist bevorzugt an der Niederspannungsseite des Fahrzeugtransformators angeschlossen. Somit ist eine kompaktere und leichtere Gestaltung der Energieversorgungseinheit möglich. Des Weiteren kann auf diese Weise der Fahrzeugtransformator als Störungsfilter dienen, um von der Energieversorgungseinheit ausgehende Störungen auszufiltern.

Gemäß einer Ausführungsform weist der Fahrzeugtransformator Klemmen und untere Wicklungsköpfe auf. Die Klemmen unterer Wicklungsköpfe sind während der Messung an die Erde angeschlossen, während ungenutzte Klemmen des Fahrzeugtransformators mit spannungsfesten Buchsenabdeckungen versehen sind.

Um einen transportablen Messaufbau zu erhalten, können die Koppeleinheiten mit der wenigstens einen Teilentladungserfassungseinheit und mit Batterien zu deren Stromversorgung auf einem gemeinsamen Träger oder in einem Gehäuse zusammengefasst sein. Durch die üblicherweise nah beieinander liegenden Anschlüsse für den Messaufbau (s. Fig. 8) wird eine derartige Zusammenfassung der benötigten Komponenten vereinfacht.

Fig. 9 zeigt beispielhaft TE einer Steckverbindung, bei der weitere Teilentladungen und Störsignale durch den Messaufbau ausgeschlossen wurden. Die gezeigten Cluster entsprechen somit, wie ein PRPD idealerweise aussehen sollte, um in einer Steckverbindung bzw. in einem Stecker auftretende TE identifizieren zu können. Es wurde die Ladung über die Phasenlage gemessen. Die Ordinatenachse bildet die Ladungshöhe in einer logarithmischen Skala in der Einheit Pikocoulomb [pC] ab, die Abszissenachse entspricht einer Zeitachse mit einer Länge von 20 Millisekunden [ms].

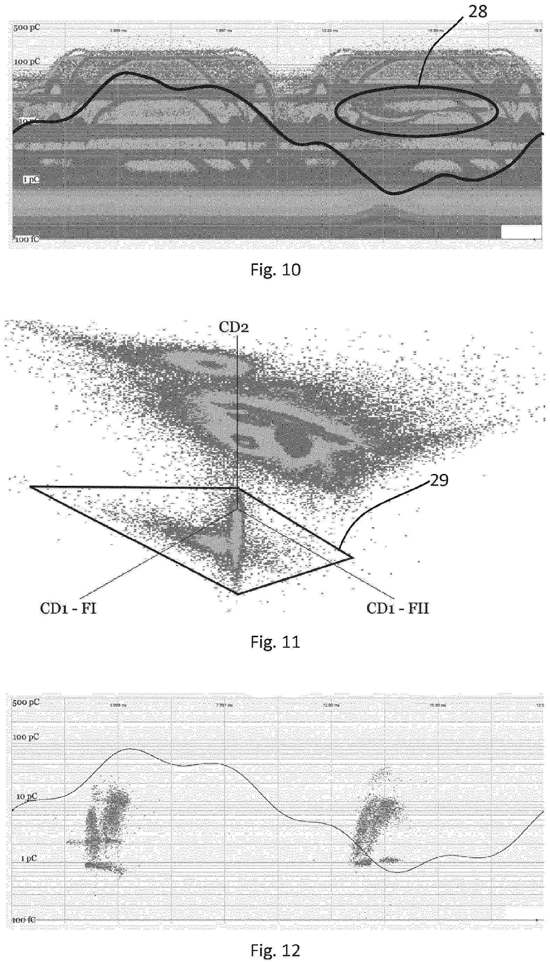

In Fig. 10 ist beispielhaft ein überlagertes PRPD mit den Mustern von Korona-Entladungen 28, Transformator-Teilentladungen und Oberflächenentladungen gezeigt. Die Muster der Stecker-TE sind aufgrund der Überlagerungen mit den anderen TE-Quellen nicht zu erkennen. Die TE-Muster können zudem durch Muster zusätzlicher Störquellen überlagert sein, die das gesamte PRPD überlagern können.

Der Grad der Störungen einer Koppeleinheit, z.B. CD1, kann geringer sein als der einer weiteren verwendeten Koppeleinheit, z.B. CD2. Dieser gemäß den Gleichungen 7 und 10 erwartete Unterschied ermöglicht eine größere Vorverstärkung der Koppeleinheit CD1 gegenüber der Koppeleinheit CD2 und aus diesem Grund ein gegenüber Fig. 10 niedrigeres Störungsband.

In Fig. 11 ist die resultierende 2CISM-Darstellung gezeigt. Die vertikale Achse ist der Koppeleinheit CD2 zugeordnet, während die zweite und die dritte Achse den beiden Bandfiltern der Koppeleinheit CD1 zugeordnet sind. Im oberen Bereich des 3PARD treten eine Vielzahl von Clustern auf, die mit den externen TE und den Störungen korrelieren. Das Cluster im unteren Bereich 29 korreliert mit der Stecker-TE.

Die Rücktransformation dieses Clusters in ein separiertes PRPD ist in Fig. 12 gezeigt. Das separierte PRPD entspricht weitestgehend einem in einer vorhergehenden Messung, ohne überlagerte Störungen erzeugten PRPD der Stecker-TE, s. Fig. 9. Somit können mit dem erfindungsgemäßen Verfahren aufgrund der geringeren Streuung der Cluster 3-Phasen-Korrelations-Diagramme (3PARD) einfacher separiert werden.

**Patentansprüche**

1. Verfahren zur Messung von Teilentladungen in Steckverbindungen für elektrische Verbindungen im Mittelspannungsbereich, insbesondere in einem Schienenfahrzeug, umfassend die Schritte:

   a. Installation einer ersten Koppeleinheit (CD1) in einem Erdungsleiter (9) eines Steckers (15) einer Steckverbindung,
   b. Installation einer zweiten Koppeleinheit (CD2) in einem Erdungsleiter (17) eines Verbindungskabels (2) zum Anschluss der Stecker (15),
   c. Anlegen von Spannung an die Steckverbindung,
   d. synchrones Messen von Teilentladungsimpulsen mit den zwei Koppeleinheiten (CD1, CD2) und Bestimmen der elektrischen Ladungen der Teilentladungsimpulse,
   e. Vergleich der gemessenen elektrischen Ladungen und Identifizieren von Teilentladungen aus der Steckverbindung.

2. Verfahren nach Anspruch 1, wobei jede Koppeleinheit (CD1, CD2) an eine digitale Teilentladungserfassungseinheit angeschlossen ist.

3. Verfahren nach Anspruch 2, wobei Teilentladungen in einem 3PARD-Diagramm mit drei Achsen abgebildet werden, wobei eine der drei Achsen des 3PARD-Diagramms der zweiten Koppeleinheit (CD2) zugeordnet ist und die beiden anderen Achsen der ersten Koppeleinheit (CD1) zugeordnet sind, wobei zwei Bandpassfilter mit zwei unterschiedlichen Mittenfrequenzen zur Bestimmung zweier elektrischer Ladungswerte verwendet werden.

4. Verfahren nach Anspruch wobei ausgewählte Bereiche des Diagramms gemäß Anspruch 3 in ein separiertes Phase Resolved Partial Discharge (PRPD) Diagramm zurücktransformiert und über einen Zeitbereich dargestellt werden.

5. Verfahren nach einem der vorhergehenden Ansprüche, wobei eine Energieversorgungseinheit mit einer Niederspannungsseite eines Fahrzeugtransformators verbunden wird.

6. Messaufbau zur Messung von Teilentladungen, umfassend:

   eine erste Koppeleinheit (CD1) zur Installation in einem Erdungsleiter (9) einer Steckverbindung für elektrische Verbindungen im Mittelspannungsbereich, insbesondere in einem Schienenfahrzeug,
   eine zweite Koppeleinheit (CD2) zur Installation in einem Erdungsleiter (17) eines Verbindungskabels der Steckverbindung,
   wenigstens eine digitale Teilentladungserfassungseinheit, die an die erste und zweite Koppeleinheit (CD1, CD2) angeschlossen ist,
   eine Rechnereinheit zur Auswertung der durch die Teilentladungserfassungseinheiten erfassten Daten, wobei die Rechnereinheit eingerichtet ist für einen Vergleich der gemessenen elektrischen Ladungen,
   eine Steckverbindung mit einem Stecker (15) für elektrische Verbindungen im Mittelspannungsbereich, insbesondere in einem Schienenfahrzeug,
   ein Verbindungskabel (2) für den Anschluss der Steckverbindung,

   **dadurch gekennzeichnet, dass** die erste Koppeleinheit (CD1) in einem Erdungsleiter (9) der Steckverbindung installiert ist und die zweite Koppeleinheit (CD2) in einem Erdungsleiter (17) des Verbindungskabels installiert ist, wobei die Teilentladungserfassungseinheit eingerichtet ist, für ein synchrones Messen von Teilentladungsimpulsen mit den zwei Koppeleinheiten (CD1, CD2) und für ein Bestimmen der elektrischen Ladungen der Teilentladungsimpulse und wobei die Rechnereinheit eingerichtet ist zum Identifizieren von Teilentladungen aus der Steckverbindung.

7. Messaufbau nach Anspruch 6, **dadurch gekennzeichnet, dass** eine Schirmung der Steckverbindung zur Verbesserung des Spektrums messbarer TE-Impulse durch leitendes Material überbrückt ist.

8. Messaufbau nach einem der Ansprüche 6 oder 7, **dadurch gekennzeichnet, dass** die Steckverbindung mit einer Folie oder einem faltbaren Metallbehälter umhüllt ist.

9. Messaufbau nach einem der Ansprüche 6 bis 8, **dadurch gekennzeichnet, dass** alle Klemmen unterer Wicklungsköpfe eines Fahrzeugtransformators an die Erde angeschlossen sind, während ungenutzte Klemmen eines Fahrzeugtransformators mit spannungsfesten Buchsenabdeckungen versehen sind.

10. Messaufbau nach einem der Ansprüche 6 bis 9, **dadurch gekennzeichnet, dass** eine Energieversorgungseinheit (26) vorgesehen ist, die mit einer Niederspannungsseite oder Mittel- oder Hochspannungsseite eines Fahrzeugtransformators verbunden werden kann.

11. Verwendung eines Messaufbau nach einem der Ansprüche 6 bis 10 zum Identifizieren von Teilentladungen aus Steckverbindungen eines Schienenfahrzeuges.

**Claims**

1. Method for measuring partial discharges in plug connections for electrical connections in the medium-voltage range, in particular in a rail vehicle, comprising the steps of

   a. installation of a first coupling unit (CD1) in an earthing conductor (9) of a plug (15) of a plug connection,
   b. installation of a second coupling unit (CD2) in an earthing conductor (17) of a connecting cable (2) for connecting the plugs (15),
   c. applying voltage to the plug connection,
   d. synchronously measuring partial discharge pulses with the two coupling units (CD1, CD2) and determining the electrical charges of the partial discharge pulses,
   e. comparing the measured electrical charges and identifying partial discharges from the connector.

2. Method according to claim 1, wherein each coupling unit (CD1, CD2) is connected to a digital partial discharge detection unit.

3. Method according to claim 2, wherein partial discharges are mapped in a 3PARD diagram with three axes, wherein one of the three axes of the 3PARD diagram is assigned to the second coupling unit (CD2) and the other two axes are assigned to the first coupling unit (CD1), wherein two bandpass filters with two different center frequencies are used to determine two electrical charge values.

4. Method according to claim 3, wherein selected areas of the diagram according to claim 3 are transformed back into a separated Phase Resolved Partial Discharge (PRPD) diagram and displayed over a time range.

5. Method according to one of the preceding claims, wherein a power supply unit is connected to a low-voltage side of a vehicle transformer.

6. Measurement setup for measuring partial discharges, comprising:

a first coupling unit (CD1) for installation in an earthing conductor (9) of a plug connection for electrical connections in the medium voltage range, in particular in a rail vehicle,
a second coupling unit (CD2) for installation in an earthing conductor (17) of a connecting cable of the plug connection,
at least one digital partial discharge detection unit, which is connected to the first and second coupling units (CD1, CD2),
a computer unit for evaluating the data recorded by the partial discharge recording units, the computer unit being set up for comparing the measured electrical charges,
a plug connection with a plug (15) for electrical connections in the medium voltage range, in particular in a rail vehicle,
a connecting cable (2) for connecting the plug connection,

**characterized in that** the first coupling unit (CD1) is installed in an earthing conductor (9) of the plug connection and the second coupling unit (CD2) is installed in an earthing conductor (17) of the connecting cable, wherein the partial discharge detection unit is set up for synchronous measurement of partial discharge pulses with the two coupling units (CD1, CD2) and for determining the electrical charges of the partial discharge pulses and wherein the computer unit is set up for identifying partial discharges from the plug connection.

7. Measurement setup according to claim 6, **characterized in that** a shielding of the plug connection is bridged by conductive material to improve the spectrum of measurable PD pulses.

8. Measurement setup according to one of claims 6 or 7, **characterized in that** the plug connection is covered with a foil or a foldable metal container.

9. Measuring setup according to one of claims 6 to 8, **characterized in that** all terminals of lower winding heads of a vehicle transformer are connected to earth, while unused terminals of a vehicle transformer are provided with voltage-resistant socket covers.

10. Measuring setup according to one of claims 6 to 9, **characterized in that** a power supply unit (26) is provided which can be connected to a low-voltage side or medium-voltage or high-voltage side of a vehicle transformer.

11. Use of a measurement setup according to one of claims 6 to 10 for identifying partial discharges from plug connections of a rail vehicle.

**Revendications**

1. Procédé permettant de mesurer des décharges partielles dans des connecteurs pour des connexions électriques dans le domaine de la moyenne tension, en particulier dans un véhicule ferroviaire, comprenant les étapes consistant à :

a. installer une première unité de couplage (CD1) dans un conducteur de terre (9) d'une fiche (15) d'un connecteur,
b. installer une seconde unité de couplage (CD2) dans un conducteur de terre (17) d'un câble de connexion (2) pour le raccordement des fiches (15),
c. appliquer une tension au connecteur,
d. mesurer de manière synchrone des impulsions de décharge partielle au moyen des deux unités de couplage (CD1, CD2) et déterminer les charges électriques des impulsions de décharge partielle,
e. comparer les charges électriques mesurées et identifier des décharges partielles provenant du connecteur.

2. Procédé selon la revendication 1, dans lequel chaque unité de couplage (CD1, CD2) est raccordée à une unité numérique de détection de décharges partielles.

3. Procédé selon la revendication 2, dans lequel les décharges partielles sont illustrées dans un diagramme 3PARD comportant trois axes, dans lequel l'un des trois axes du diagramme 3PARD est associé à la seconde unité de couplage (CD2) et les deux autres axes sont associés à la première unité de couplage (CD1), dans lequel deux filtres passe-bande comportant deux fréquences centrales différentes sont utilisés pour la détermination de deux valeurs de charge électriques.

4. Procédé selon la revendication, dans lequel des zones sélectionnées du diagramme selon la revendication 3 sont retransformées en un diagramme de décharge partielle à résolution de phase (Phase Resolved Partial Discharge, PRPD) séparé et représentées sur une plage temporelle.

5. Procédé selon l'une des revendications précédentes, dans lequel une unité d'alimentation en énergie est connectée à un côté basse tension d'un transformateur de véhicule.

6. Structure de mesure permettant de mesurer des décharges partielles, comprenant :

une première unité de couplage (CD1) destinée à être installée dans un conducteur de terre (9) d'un connecteur pour des connexions électriques dans le domaine de la moyenne tension, en particulier dans un véhicule ferroviaire, une seconde unité de couplage (CD2) destinée à être installée dans un conducteur de terre (17) d'un câble de connexion du connecteur, au moins une unité numérique de détection de décharges partielles qui est raccordée à la première et à la seconde unité de couplage (CD1, CD2), une unité de calcul permettant d'évaluer les données détectées par les unités de détection de décharges partielles, dans laquelle l'unité de calcul est configurée pour une comparaison des charges électriques mesurées, un connecteur comportant une fiche (15) pour des connexions électriques dans le domaine de la moyenne tension, en particulier dans un véhicule ferroviaire, un câble de connexion (2) pour le raccordement du connecteur, **caractérisée en ce que** la première unité de couplage (CD1) est installée dans un conducteur de terre (9) du connecteur et la seconde unité de couplage (CD2) est installée dans un conducteur de terre (17) du câble de connexion, dans laquelle l'unité de détection de décharges partielles est configurée pour une mesure de manière synchrone d'impulsions de décharge partielle au moyen des deux unités de couplage (CD1, CD2) et pour une détermination des charges électriques des impulsions de décharge partielle et dans laquelle l'unité de calcul est configurée pour identifier des décharges partielles provenant du connecteur.

7. Structure de mesure selon la revendication 6, **caractérisée en ce qu'**un blindage du connecteur est ponté par un matériau conducteur pour améliorer le spectre des impulsions de décharge partielle mesurables.

8. Structure de mesure selon l'une des revendications 6 ou 7, **caractérisée en ce que** le connecteur est enveloppé d'un film ou d'un récipient métallique pliable.

9. Structure de mesure selon l'une des revendications 6 à 8, **caractérisée en ce que** toutes les bornes de têtes d'enroulements inférieures d'un transformateur de véhicule sont raccordées à la terre, tandis que les bornes inutilisées d'un transformateur de véhicule sont pourvues d'éléments de recouvrement de prise résistants à la tension.

10. Structure de mesure selon l'une des revendications 6 à 9, **caractérisée en ce qu'**une unité d'alimentation en énergie (26) est prévue, laquelle est apte à être connectée à un côté basse tension ou à un côté moyenne ou haute tension d'un transformateur de véhicule.

11. Utilisation d'une structure de mesure selon l'une des revendications 6 à 10 pour l'identification de décharges partielles provenant de connecteurs d'un véhicule ferroviaire.

Fig. 1

Stand der Technik

Fig. 2

Fig. 3

17

9

CD2

19

18

CD1

Fig. 4

FFT of PD Input  III    II                                        2 MHz/div
                                                                  5 dBm/div

-60.000 dBm

-70.000 dBm

-80.000 dBm

2.000 MHz        6.000 MHz      10.00 MHz      14.00 MHz      18.00 MHz

Fig. 5

Fig. 6

Fig. 7

Fig. 8

Fig. 9

Fig. 10

Fig. 11

Fig. 12

**IN DER BESCHREIBUNG AUFGEFÜHRTE DOKUMENTE**

**In der Beschreibung aufgeführte Patentdokumente**

- CN 104698355 A

- JP H0815367 A

**In der Beschreibung aufgeführte Nicht-Patentliteratur**

- Wide and narrow band PD detection in plug-in cable connectors in the UHF range. **DENISSOV D et al.** CONDITION MONITORING AND DIAGNOSIS, 2008. CMD 2008. INTERNATIONAL CONFERENCE ON. IEEE, 21. April 2008, 1056-1059
- On-line partial discharge source location in single-core cables with multi sheath-ground connections. **BABAEE ABBAS et al.** IEEE TRANSACTIONS ON DIELECTRICS AND ELECTRICAL INSULATION. IEEE SERVICE CENTER, 01. April 2015, vol. 22, 1031-1040

- A novel method to locate PD in polymeric cable systems based on amplitude-frequency (AF) map. **CAVALLINI A et al.** IEEE TRANSACTIONS ON DIELECTRICS AND ELECTRICAL INSULATION. IEEE SERVICE CENTER, 01. Juni 2007, vol. 14, 726-734
- Discrimination of multiple PD sources using wavelet decomposition and principal component analysis. **HAO L et al.** IEEE TRANSACTIONS ON DIELECTRICS AND ELECTRICAL INSULATION. IEEE SERVICE CENTER, 01. Oktober 2011, vol. 18, 1702-1711